# EUROPEAN PATENT APPLICATION

(11) **EP 4 797 894 A1**
(43) Date of publication of application: **26.08.2026**
(21) Application number: 24953255.7
(22) Date of filing: 30.12.2024
(51) Int. Cl.: H05K 7/20

(54) **ENERGY STORAGE HIGH-VOLTAGE BOX AND ENERGY STORAGE SYSTEM**

(30) Priority: 05.11.2024 CN 202422698220 U
(71) Applicant: Eve Energy Storage Co., Ltd, Wuhan, Hubei 430074 (CN)
(72) Inventor: SUN, Yuanbiao, Wuhan, Hubei 430074 (CN); ZHAO, Zihui, Wuhan, Hubei 430074 (CN); YI, Haohao, Wuhan, Hubei 430074 (CN)
(74) Representative: Studio Torta S.p.A.
(86) International application number: PCT/CN2024/143831
(87) International publication number: WO 2026/097687

(57) **Abstract**

The application provides an energy storage high-voltage box and an energy storage system. The energy storage high-voltage box includes a box body, a heat-generating assembly, a heat dissipation component, and a spoiler. The box body is formed with an mounting cavity. The heat-generating assembly is arranged in the mounting cavity. The heat dissipation component is embedded on the wall of the box body. The heat dissipation component includes a heat absorption portion and a heat dissipation portion which are connected to each other. The heat absorption portion is arranged in the mounting cavity, and the heat dissipation portion is arranged outside the mounting cavity. The spoiler is arranged in the mounting cavity, and the spoiler is configured to drive gas in the mounting cavity to flow.

## Description

This application claims priority to Chinese Patent Application No. 202422698220.8, filed on November 5, 2024, the disclosure of which is incorporated herein by reference in its entirety.

### TECHNICAL FIELD

The present application relates to the technical field of energy storage equipment, and more particularly, to an energy storage high-voltage box and an energy storage system.

### BACKGROUND

The energy storage high-voltage box is an important part of the energy storage system. The energy storage high-voltage box is provided with heat-generating elements such as a fuse, a copper bar, and the like.

### SUMMARY

In the related art, there is a problem in that the internal temperature is higher.

In a first aspect, according to the present application, it is provided an energy storage high-voltage box including:
a box body formed with a mounting cavity;
a heat-generating assembly disposed in the mounting cavity;
a heat dissipation component embedded on a wall of the box body, wherein the heat dissipation component comprises a heat absorption portion and a heat dissipation portion connected to each other, the heat absorption portion is located in the mounting cavity, and the heat dissipation portion is located outside the mounting cavity; and
a spoiler disposed within the mounting cavity, wherein the spoiler is configured to drive gas to flow in the mounting cavity.

In a second aspect, according to the present application, it is provided an energy storage system including the above-mentioned energy storage high-voltage box.

### BENEFICIAL EFFECT

According to the energy storage high-voltage box provided in the present application, the heat absorption portion is provided in the mounting cavity, and the heat dissipation portion is provided outside the mounting cavity. In this way, heat in the mounting cavity can be transferred to the heat dissipation portion through the heat absorption portion, and then directly dissipated to the external environment, thereby accelerating the heat dissipation speed in the mounting cavity. At the same time, the gas in the mounting cavity is driven to flow by the spoiler, so that the heat exchange speed between the heat in the mounting cavity and the heat absorption portion is accelerated, the heat in the mounting cavity can be quickly transferred to the external environment, and the temperature of the box body is reduced. And the gas in the mounting cavity is driven to flow by the spoiler, so that the temperature uniformity in the mounting cavity can be improved, and the temperature at the local position is prevented from being excessively high.

### BRIEF DESCRIPTION OF THE DRAWINGS

FIG. 1 is a first schematic structural diagram of an energy storage high-voltage box according to embodiments of the present application;
FIG. 2 is a second schematic structural diagram of an energy storage high-voltage box according to embodiments of the present application;
FIG. 3 is a schematic structural diagram of a heat dissipation component according to embodiments of the present application;
FIG. 4 is a partial schematic diagram of an energy storage high-voltage box according to embodiments of the present application; and
FIG. 5 is a schematic structural diagram of an energy storage high-voltage box according to embodiments of the present application, in which a heat conductive connection plate is a side wall of a body.

### DETAILED DESCRIPTION

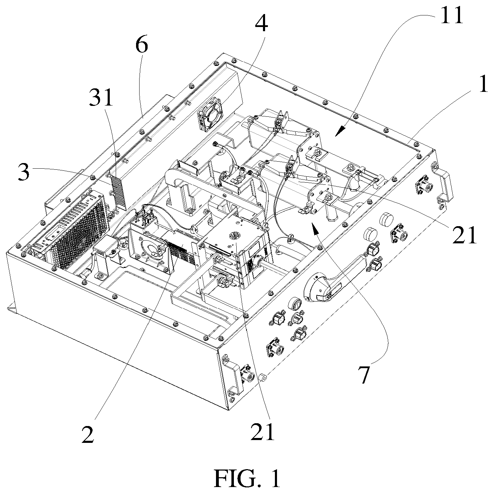

The embodiments of the present application discloses an energy storage high-voltage box. Referring to FIGS. 1, 2, and 3, an energy storage high-voltage box includes a box body 1, a heat-generating assembly 2, a heat dissipation component 3, and a spoiler 4. The box body 1 is formed with a mounting cavity 11. The heat-generating assembly 2 is disposed in the mounting cavity 11. The heat dissipation component 3 is embedded on the wall of the box body 1. The heat dissipation component 3 includes a heat absorption portion 31 and a heat dissipation portion 32 connected to each other. The heat absorption portion 31 is disposed in the mounting cavity 11. The heat dissipation portion 32 is disposed outside the mounting cavity 11. The spoiler 4 is disposed in the mounting cavity 11. The spoiler 4 is configured to drive gas to flow in the mounting cavity 11.

According to the energy storage high-voltage box according to the embodiments of the present application, the heat absorption portion 31 is provided in the mounting cavity 11, and the heat dissipation portion 32 is provided outside the mounting cavity 11, so that heat in the mounting cavity 11 can be transferred to the heat dissipation portion 32 through the heat absorption portion 31, and then directly radiated to the external environment, thereby increasing the heat dissipation speed in the mounting cavity 11. At the same time, the gas in the mounting cavity 11 is driven to flow by the spoiler 4, so that the heat exchange speed between heat in the mounting cavity 11 and the heat absorption portion 31 is increased, and the heat in the mounting cavity 11 can be rapidly transferred to the external environment, thereby reducing the temperature of the box body 1. The gas in the mounting cavity 11 is driven to flow by the spoiler 4, so that the temperature uniformity in the mounting cavity 11 can be improved, and the temperature at the local position can be prevented from being excessively high.

In some examples, the spoiler 4 is, for example, a spoiler fan or an exhauster.

In some examples, the heat-generating assembly 2 includes, for example, at least one of an over-current copper bar, a splitter, a pre-charge resistor, a isolating switch, and a fuse.

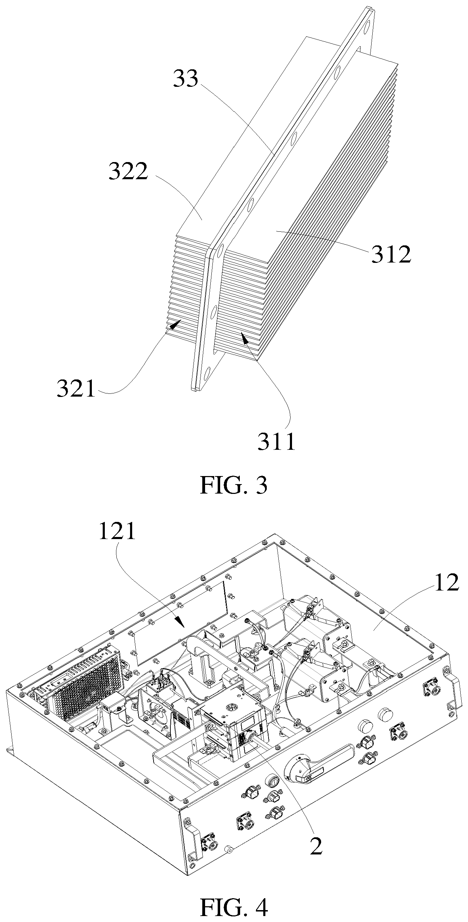

In some embodiments, referring to FIGS. 1 and 3, the heat absorption portion 31 is formed with a first air duct 311 communicating with the mounting cavity 11.

It will be appreciated that the gas in the mounting cavity 11 carries the heat emitted from the heat-generating assembly 2, and the first air duct 311 communicating with the mounting cavity 11 is formed in the heat absorption portion 31. In this way, when the spoiler 4 drives the gas in the mounting cavity 11 to flow, the gas in the mounting cavity 11 flows into the first air duct 311, so that the gas carrying the heat can enter the first air duct 311 to exchange heat with the heat absorption portion 31, thereby increasing the heat absorbing speed of the heat absorption portion 31 and increasing the heat dissipation speed of the energy storage high-voltage box.

It will be appreciated that by forming the first air duct 311 in the heat absorption portion 31, the contact area between the heat absorption portion 31 and the gas in the mounting cavity 11 can be increased. That is, the heat exchange area of the heat absorption portion 31 can be increased. So, the speed of the heat absorption portion 31 absorbing heat from the mounting cavity 11 can be increased, thereby achieving rapid heat dissipation of the energy storage high-voltage box.

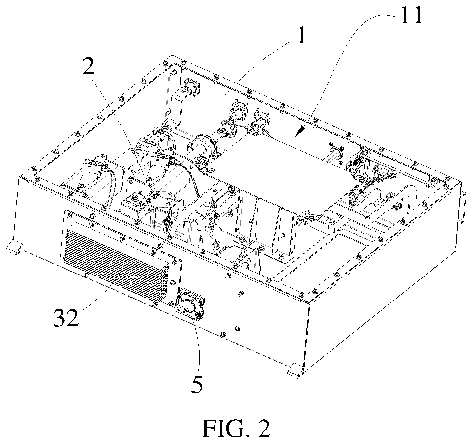

In some embodiments, referring to FIGS. 2 and 3, the heat dissipation portion 32 is formed with a second air duct 321. The energy storage high-voltage box further includes a heat dissipation fan 5 provided at the heat dissipation portion 32. The heat dissipation fan 5 is provided to drive the gas to flow at the second air duct 321.

It will be appreciated that the heat absorption portion 31 can transfer heat within the mounting cavity 11 to the heat dissipation portion 32. By providing the heat dissipation fan 5 at the heat dissipation portion 32, the heat dissipation fan 5 drives the gas at the second air duct 321 to flow, thereby increasing the speed at which the heat of the heat dissipation portion 32 is dissipated to the external environment. The faster the heat dissipated by the heat dissipation portion 32, the faster the heat exchange speed between the heat dissipation portion 32 and the heat absorption portion 31, and the faster the heat dissipating speed of the energy storage high-voltage box.

It is understood that by forming the second air duct 321 at the heat dissipation portion 32, the contact area between the heat dissipation portion 32 and the external environment can be increased. That is, the heat dissipation area of the heat dissipation portion 32 can be increased. The heat dissipation speed of the heat dissipation portion 32 can be accelerated by cooperating with the heat dissipation fan 5.

In some embodiments, referring to FIG. 3, the heat absorption portion 31 includes at least two heat absorption fins 312. The at least two heat absorption fins 312 are disposed side by side. The first air duct 311 is formed between two adjacent heat absorption fins 312.

It will be appreciated that each of the heat absorption fins 312 can exchange heat with the gas in the mounting cavity 11, thereby ensuring the heat absorption speed of the heat absorption portion 31. At the same time, the first air duct 311 is formed between the two adjacent heat absorption fins 312, so that the heat in the mounting cavity 11 can flow to be between the two adjacent heat absorption fins 312 along with the flow of the gas, thereby ensuring the heat absorbing area of the heat absorption fins 312 and increasing the heat absorbing speed of the heat absorption portion 31.

In some examples, the heat absorption portion 31 includes at least three heat absorption fins 312.

In some embodiments, referring to FIG. 3, the heat dissipation portion 32 includes at least two heat dissipation fins 322. The at least two dissipation fins 322 are disposed side by side. A second air duct 321 is formed between two adjacent heat dissipation fins 322.

It will be appreciated that each of the heat dissipation fins 322 can exchange heat with the gas in the external environment, thereby ensuring the heat dissipating speed of the heat dissipation portion 32. Each of the heat dissipation fins 322 can exchange heat with the heat absorption portion 31, thereby ensuring that the heat absorption portion 31 can rapidly transfer heat in the mounting cavity 11 to the heat dissipation portion 32. At the same time, the second air duct 321 is formed between two adjacent heat dissipation fins 322, thereby ensuring the contact area between the heat dissipation fins 322 and the external environment and increasing the heat dissipating speed.

In some embodiments, referring to FIGS. 1 and 2, the energy storage high-voltage box further includes a cover plate 6 connected to the outer wall of the box body 1. An accommodating space is formed between the cover plate 6 and the outer wall of the box body 1. Both the heat dissipation portion 32 and the heat dissipating fan 5 are located in the accommodating space.

It will be appreciated that the cover plate 6 covers the heat dissipation portion 32 and the heat dissipation fan 5. The cover plate 6 can protect the heat dissipation portion 32 and the heat dissipation fan 5. At the same time, the accommodating space is formed by the cover plate 6 and the outer wall of the box body 1. The heat dissipation portion 32 and the heat dissipation fan 5 are provided in the accommodating space. So, the heat dissipation fan 5 can rapidly drive the gas in the accommodating space to flow, thereby rapidly driving the gas at the heat dissipation portion 32 to flow.

It is to be understood that, if the heat dissipation portion 32 and the heat dissipation fan 5 are not covered by the cover plate 6, the heat dissipation fan 5 further drives the flow of the gas that is farther away from the heat dissipation portion 32 during the operation of the heat dissipation fan 5, thereby reducing the gas flow velocity at the heat dissipation portion 32, which is not help for the rapid heat dissipation of the heat dissipation portion 32.

In some examples, the heat dissipating fan 5 is disposed adjacent to the heat dissipation portion 32 in the accommodating space, so that the heat dissipating fan 5 can rapidly drive the gas at the heat dissipation portion 32 to flow.

In some embodiments, referring to FIGS. 1 and 2, a third air duct 7 is formed between the heat-generating assembly 2 and the inner wall of the box body 1. The third air duct 7 communicates with the first air duct 311.

It will be appreciated that the spoiler 4 may drive the gas in the mounting cavity 11 to flow along the third air duct 7. Since the third air duct 7 is adjacent to the heat-generating assembly 2, the gas can carry away the heat of the heat-generating assembly 2 as the gas flows in the third air duct 7. At the same time, since the third air duct 7 communicates with the first air duct 311, the gas carrying the heat of the heat-generating assembly 2 flows to the first air duct 311 to realize rapid heat exchange between the heat absorption portion 31 and the heat-generating assembly 2.

In some examples, the third air duct 7 is arranged around the heat-generating assembly 2, so that the gas flowing along the third air duct 7 can completely dissipate heat from the heat-generating assembly 2, thereby increasing the heat dissipation speed of the heat-generating assembly 2.

In some embodiments, referring to FIGS. 1 and 2, the heat-generating assembly 2 includes at least two heat-generating elements 21. A gap is formed between adjacent two heat-generating elements 21. The gap communicates with the first air duct 311.

It will be appreciated that the two adjacent heat-generating elements 21 are spaced apart to form a gap therebetween, so that when the spoiler 4 drives the gas in the mounting cavity 11 to flow, the gas flows through the gap between the two adjacent heat-generating elements 21, thereby increasing the heat dissipation speed of the heat-generating element 21. So, the gas can effectively bring the heat of the heat-generating elements 21 to the heat absorption portion 31, thereby increasing the heat dissipation speed of the energy storage high-voltage box.

At the same time, the gap is formed between the two adjacent heat-generating elements 21, so that it is possible to prevent the contact between the two adjacent heat-generating elements 21 from causing the heat at the contact position to be difficult to dissipate. So, it is possible to prevent the occurrence of an excessively high temperature between the two adjacent heat-generating elements 21.

In some embodiments, referring to FIG. 3, the heat dissipation component 3 further includes a heat conductive connection plate 33 that connects the heat dissipation portion 32 and the heat absorption portion 31. The heat conductive connection plate 33 is embedded on the wall of the box body 1.

It will be appreciated that the heat dissipation portion 32 and the heat absorption portion 31 are provided on both sides of the heat conductive connection plate 33, respectively. The heat conductive connection plate 33 is embedded on the wall of the box body 1 so that the heat dissipation portion 32 is located outside the mounting cavity 11, and the heat absorption portion 31 is located in the mounting cavity 11. The heat dissipation portion 32 can transfer heat in the mounting cavity 11 to the heat dissipation portion 32 through the heat conductive connection plate 33, so that the heat dissipation component 3 can rapidly dissipate heat from the box body 1.

It will be appreciated that the heat inside the mounting cavity 11 can also be transferred to the external environment through the heat conductive connection plate 33, thereby increasing the heat dissipation speed of the box body 1.

In some embodiments, referring to FIGS. 3 and 4, the box body 1 includes a main body 12 formed with a connection cavity 121. The heat conductive connection plate 33 is embedded in the connection cavity 121. The heat conductive connection plate 33 and the main body 12 are enclosed to form the mounting cavity 11.

It will be appreciated that the heat conductive connection plate 33 is embedded at the connection cavity 121 so that the heat conductive connection plate 33 and the main body 12 are enclosed to form the mounting cavity 11. In other words, the heat conductive connection plate 33 is one of the elements of the heat dissipation component 3, and also one of the elements of the box body 1, so that the dual-use of the heat conductive connection plate 33 may be realized, thereby facilitating simplification of the structure of the energy storage high-voltage box.

Illustratively, the heat conductive connection plate 33 may be reused to be one of side walls of the main body 12 or may be reused to be a part of one of the side walls of the main body 12.

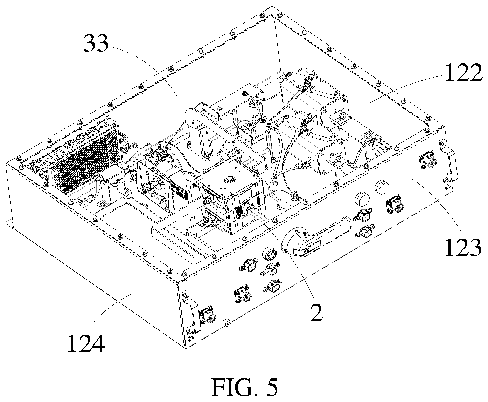

In some embodiments, referring to FIG. 5, the main body 12 includes a first side plate 122, a second side plate 123, and a third side plate 124 connected in sequence. The heat conductive connection plate 33 is fixedly connected to the first side plate 122 and the third side plate 124 to form the side walls of the main body 12.

It will be appreciated that the heat conductive connection plate 33 is used as one of the side plates of the main body 12, and the heat conductive connection plate 33 is fixedly connected to the first side plate 122 and the third side plate 124, so that the heat conductive connection plate 33, the first side plate 122, the second side plate 123, and the third side plate 124 can be sequentially connected to form the side walls of the main body 12, thereby realizing the reuse of the heat conductive connection plate 33 as the side plate of the main body 12, and further facilitating simplification of the structure of the main body 12.

It will be appreciated that the main body 12 further includes a top plate and a bottom plate. One end of the heat conductive connection plate 33, one end of the first side plate 122, one end of the second side plate 123, and one end of the third side plate 124 are connected to the top plate; and the other end of the heat conductive connection plate 33, the other end of the first side plate 122, the other end of the second side plate 123, and the other end of the third side plate 124 are connected to the bottom plate.

In some embodiments, the heat conductive connection plate 33 and the main body 12 are made of the same material, and the heat conductive connection plate 33 is fixedly connected to the main body 12 by welding.

It will be appreciated that when the heat conductive connection plate 33 and the main body 12 are made of the same material, the heat conductive connection plate 33 and the main body 12 can be directly and fixedly connected together by welding, thereby improving the stability and the sealability of the connection between the heat conductive connection plate 33 and the main body 12.

In some embodiments, the heat conductive connection plate 33 and the main body 12 are of different materials, and the heat conductive connection plate 33 is fixedly connected to the main body 12 by at least one of a snap connection, a threaded connection, and an interference fit.

It will be appreciated that when the heat conductive connection plate 33 and the main body 12 are of different materials, it is difficult to fixedly connect the main body 12 and the heat conductive connection plate 33 together by welding. Thus, in the present embodiment, the heat conductive connection plate 33 and the main body 12 are securely connected together by at least one of the snap connection, the threaded connection, and the interference fit.

In some examples, a sealing member is provided at the junction of the heat conductive connection plate 33 and the main body 12. It will be appreciated that the sealing performance at the junction of the heat conductive connection plate 33 and the main body 12 can be effectively improved by the sealing member, so that penetration of the cooling fluid into the mounting cavity 11 can be avoided.

Embodiments of the present application further disclose an energy storage system including the above-described energy storage high-voltage box.

According to the energy storage system according to the embodiments of the present application, the heat absorption portion 31 is provided in the mounting cavity 11, and the heat dissipation portion 32 is provided outside the mounting cavity 11. So, the heat in the mounting cavity 11 can be transferred to the heat dissipation portion 32 through the heat absorption portion 31, and then directly radiated to the external environment, thereby increasing the heat dissipation speed in the mounting cavity 11. At the same time, the gas in the mounting cavity 11 is driven to flow by the spoiler 4, so that the heat exchange speed between heat in the mounting cavity 11 and the heat-absorbing portion 31 is increased, thereby enabling the heat in the mounting cavity 11 to be rapidly transferred to the external environment. The gas in the mounting cavity 11 is driven by the spoiler 4 to flow, so that the temperature uniformity in the mounting cavity 11 can be improved, and the use safety of the energy storage system can be improved by avoiding that the temperature at the local position is too high.

It should be noted that the energy storage system may be a vehicle or an energy storage charging station. It should be noted that the foregoing is merely illustrative of the energy storage system, which does not specifically limit the energy storage system.

## Claims

1. An energy storage high-voltage box, comprising:
a box body formed with a mounting cavity;
a heat-generating assembly disposed in the mounting cavity;
a heat dissipation component embedded on a wall of the box body, wherein the heat dissipation component comprises a heat absorption portion and a heat dissipation portion connected to each other, the heat absorption portion is located in the mounting cavity, and the heat dissipation portion is located outside the mounting cavity; and
a spoiler disposed within the mounting cavity, wherein the spoiler is configured to drive gas to flow in the mounting cavity.

2. The energy storage high-voltage box according to claim 1, wherein the heat absorption portion is formed with a first air duct communicating with the mounting cavity.

3. The energy storage high-voltage box according to claim 1, wherein the heat dissipation portion is provided with a second air duct, the energy storage high-voltage box further comprises a heat dissipation fan, the heat dissipation fan is provided at the heat dissipation portion, and the heat dissipation fan is configured to drive gas to flow at the second air duct.

4. The energy storage high-voltage box according to claim 2, wherein the heat absorption portion comprises at least two heat absorption fins, the at least two heat absorption fins are arranged side by side, and the first air duct is formed between adjacent two of the at least two heat absorption fins.

5. The energy storage high-voltage box according to claim 3, wherein the heat dissipation portion comprises at least two heat dissipation fins, the at least two heat dissipation fins are arranged side by side, and the second air duct is formed between adjacent two of the at least two heat dissipation fins.

6. The energy storage high-voltage box according to claim 3, wherein the energy storage high-voltage box further comprises a cover plate connected to an outer wall of the box body, an accommodating space is formed between the cover plate and the outer wall of the box body, and the heat dissipation portion and the heat dissipation fan are both located in the accommodating space.

7. The energy storage high-voltage box according to claim 2, wherein a third air duct is formed between the heat-generating assembly and an inner wall of the box body, and the third air duct communicates with the first air duct.

8. The energy storage high-voltage box according to claim 2, wherein the heat-generating assembly comprises at least two heat-generating elements, a gap is formed between adjacent two of the at least two heat-generating elements, and the gap communicates with the first air duct.

9. The energy storage high-voltage box according to any one of claims 1 to 8, wherein the heat dissipation component further comprises a heat conductive connection plate connecting the heat dissipation portion and the heat absorption portion, and the heat conductive connection plate is embedded on the wall of the box body.

10. The energy storage high-voltage box according to claim 9, wherein the box body includes a main body, the main body is formed with a connection cavity, the heat conductive connection plate is embedded in the connection cavity, and the heat conductive connection plate and the main body are enclosed to form the mounting cavity.

11. The energy storage high-voltage box according to claim 10, wherein the main body includes a first side plate, a second side plate, and a third side plate connected in sequence, and the heat conductive connection plate is fixedly connected to the first side plate and the third side plate to form side walls of the main body.

12. The energy storage high-voltage box according to claim 10, wherein the heat conductive connection plate and the main body are made of the same material, and the heat conductive connection plate is fixedly connected to the main body by welding.

13. The energy storage high-voltage box according to claim 10, wherein the heat conductive connection plate and the main body are of different materials, and the heat conductive connection plate is fixedly connected to the main body by at least one of a snap connection, a threaded connection and an interference fit.

14. An energy storage system comprising the energy storage high-voltage box according to any one of claims 1 to 13.
